# DEMANDE DE BREVET EUROPEEN

(11) **EP 1 355 357 A1**
(43) Date de publication de la demande: **22.10.2003**
(21) Numéro de dépôt: 02405315.9
(22) Date de dépôt: 18.04.2002
(51) Int. Cl.: H01L 27/108, H01L 27/12

(54) **Dispositif semi-conducteur porteur d'une charge électrique**

(71) Demandeur: Innovative Silicon SA, 1015 Lausanne (CH); Ecole Polytechnique Fédérale de Lausanne (EPFL), 1015 Lausanne (CH)
(72) Inventeur: Fazan, Pierre, 2525 Le Landeron (CH); Okhonin, Serguei, 1005 Lausanne (CH)
(74) Mandataire: Vinsome, Rex Martin

(57) **Abrégé**

L'invention concerne un dispositif semi-conducteur à mémoire, du type comportant des transistors SOI, formé sur un substrat comprenant :
- une plaque de base (12) en matériau semi-conducteur,
- une couche isolante (14) disposée sur la plaque de base,
- une première couche de matériau semi-conducteur (16), recouvrant la couche isolante (14) et dans laquelle sont formés, par dopage, les sources (18), drains (20) et corps (22) desdits transistors,
- un film diélectrique (24) disposé entre la source (18) et le drain (20) de chaque transistor et revêtu d'une couche conductrice formant la grille (26).

Selon l'invention, le dispositif comporte une deuxième couche de matériau semi-conducteur (38) fortement dopé disposée au moins localement en dessous de la première couche (16). Il est ainsi possible de former, dans le corps (22) des transistors, une zone neutre permettant le stockage de charges électriques, même dans des transistors de type FD-SOI.

## Description

La présente invention se rapporte aux dispositifs semi-conducteurs porteurs d'une charge électrique. Elle concerne, plus particulièrement, un dispositif semi-conducteur à mémoire utilisant des transistors SOI, un substrat destiné à la fabrication de circuits intégrés de type SOI et un transistor SOI à déplétion partielle. La notion de mémoire est à prendre ici au sens large. Elle englobe tous les dispositifs dans lesquels une charge électrique peut être stockée durant un temps plus ou moins long, pour gérer une information, mais aussi pour toute autre application.

L'invention s'applique, tout particulièrement, à la réalisation de mémoires connues sous le nom de DRAM (de l'anglais « Dynamic Random Access Memory), par exemple, du type décrit dans la demande de brevet EP 01810587.4. Ces mémoires comportent un circuit de commande et des cellules disposées dans une structure matricielle, chaque cellule étant formée d'un transistor à effet de champ, lequel comporte, de manière classique, un drain, une source, une grille et un corps compris entre la source et le drain, fréquemment appelé du terme anglais de « body ». Le drain, la source et la grille constituent les bornes du transistor. Selon les potentiels appliqués à ces bornes, un canal se forme dans le corps, permettant la mobilité de charges, au travers du corps, entre la source et le drain.

Ces mémoires utilisent des transistors de type SOI (de l'anglais « silicon on insulator ») à effet de champ dont une description plus complète se trouve dans l'ouvrage intitulé « SOI Technology: Materials to VLSI » 2^{nd} Edition, Kluwer, Boston 1997.

Comme expliqué dans la demande mentionnée ci-dessus, il est possible de stocker, dans le corps du transistor, une charge électrique formée de particules chargées (électrons ou trous). De manière classique pour une mémoire binaire de type DRAM, celle-ci peut avoir deux états « 0 » et « 1 », fonction de la charge stockée. Cette dernière est introduite dans le corps par des impulsions appliquées par le circuit de commande aux bornes du transistor.

Les transistors utilisés dans ce type de dispositif sont de type PD-SOI. Cette abréviation vient de l'anglais « partially depleted, silicon on insulator ». Ils sont formés dans la couche de silicium déposée sur la couche isolante. Pour chacun des transistors, la source, le corps et le drain sont disposés dans un même plan, dans toute l'épaisseur de la couche de silicium. Cette dernière est recouverte d'un film diélectrique dans sa partie constituant le corps et au-delà jusqu'à déborder sur la source et le drain. La grille recouvre le film diélectrique.

Les caractéristiques de la source, du corps et du drain sont obtenues par dopage de la couche de silicium. Pour qu'une charge puisse être stockée dans le corps, il est nécessaire que celui-ci présente, dans sa partie médiane, une couche de silicium suffisamment épaisse pour que le silicium comporte une zone médiane qui ne présente pas de déplétion, appelée zone neutre. C'est dans cette dernière que la charge électrique est stockée. De tels transistors sont appelés, par la suite, « à déplétion partielle » ou PD.

On connaît, par ailleurs, des dispositifs comportant des transistors de type FD-SOI (de l'anglais « fully depleted, silicon on insulator ») qui sont appelés, ci-après, à déplétion complète. Dans de tels dispositifs, la couche de silicium est plus mince et/ou le dopage est moins important, de telle sorte qu'il n'y a pas de zone médiane neutre. Il n'est donc ainsi pas possible d'y stocker une charge. La technologie présente, par contre, de nombreux avantages, par exemple, un excellent comportement de canal court, généralement défini sous le vocable anglais « short-channel behaviour » et une fréquence de coupure très rapide. Ces très bons résultats sont obtenus à cause de la faible épaisseur de la couche de silicium.

Il serait donc très avantageux de pouvoir disposer de transistors ayant une couche semi-conductrice mince et travaillant dans un mode à déplétion partielle, par exemple, pour que l'on puisse y stocker de l'information. Le but de la présente invention est, entre autres, de permettre la réalisation de tels transistors.

De façon plus précise, l'invention concerne un dispositif semi-conducteur à mémoire, du type comportant des transistors SOI qui comprennent une source, un drain, une grille et un corps, et formé sur un substrat comprenant :
- une plaque de base en matériau semi-conducteur,
- une couche isolante disposée sur la plaque de base,
- une première couche de matériau semi-conducteur recouvrant la couche isolante et dans laquelle sont formés, par dopage, les sources, drains et corps desdits transistors, et
- un film diélectrique disposé entre la source et le drain de chaque transistor et revêtu d'une couche conductrice formant la grille,
caractérisé en ce qu'une deuxième couche de matériau semi-conducteur fortement dopé est disposée au moins localement en dessous de la première couche.

De façon avantageuse, les transistors utilisés sont de type FD-SOI et la première couche présente une épaisseur inférieure à 100 nm.

L'invention concerne également un substrat destiné à la fabrication de circuits intégrés de type SOI, comportant
- une plaque de base en matériau semi-conducteur dopé,
- une couche isolante disposée sur la plaque de base, et
- une première couche de matériau semi-conducteur recouvrant la couche isolante de manière homogène et destinée à être traitée par dopage pour y former des sources, drains et corps de transistors à effet de champ,
caractérisé en ce qu'une deuxième couche de matériau semi-conducteur fortement dopé est disposée au moins localement en dessous de la première couche.

Le substrat selon l'invention comporte encore avantageusement les principales caractéristiques suivantes :
- la deuxième couche est formée dans la plaque de base ;
- cette deuxième couche est attenante à la première ;
- cette couche forme un caisson et n'occupe qu'une part de la surface de la plaque de base.

La présente invention concerne aussi un transistor à effet de champ de type SOI à déplétion partielle et comportant un substrat formé d'une plaque de base en matériau semi-conducteur, d'une couche isolante disposée sur la plaque de base et d'une couche semi-conductrice revêtant la couche isolante et dans laquelle sont formés la source, le drain et le corps, et d'un film diélectrique recouvrant la couche semi-conductrice dans l'espace compris entre la source et le drain et revêtu d'une couche conductrice formant la grille, caractérisé en ce qu'il comporte une zone fortement dopée disposée au voisinage de la source, du corps et du drain, du côté opposé à celui portant le film diélectrique.

Le transistor selon l'invention comporte encore, de préférence, les principales caractéristiques suivantes :
- la zone dopée forme un caisson dans la plaque de base, directement adjacent à la couche isolante ;
- cette zone dopée est directement formée dans la couche semi-conductrice, à l'interface avec la couche isolante ;
- l'épaisseur de la couche semi-conductrice est inférieure à 100 nm.

D'autres caractéristiques de l'invention ressortiront de la description qui va suivre, faite en regard du dessin annexé, dans lequel:
- les figures 1 et 2 représentent respectivement, et de manière très schématique, un substrat destiné à la fabrication de circuits intégrés et un transistor équipant de tels circuits, en a faisant appel à la technologie « silicium sur couche isolante » ou SOI et en b selon la technologie appelée « bulk » ;
- les figures 3, 4 et 5 montrent, en a et de manière schématique, respectivement des transistors de type « bulk », PD-SOI et FD-SOI, et en b des courbes illustrant les variations du potentiel à l'intérieur du corps de ces transistors ; et
- la figure 6 se rapporte à un transistor selon l'invention.

Dans les figures, les échelles relatives, notamment, aux épaisseurs, ne sont pas respectées. Les exemples donnés ont été réalisés en technologie 0,13 µm.

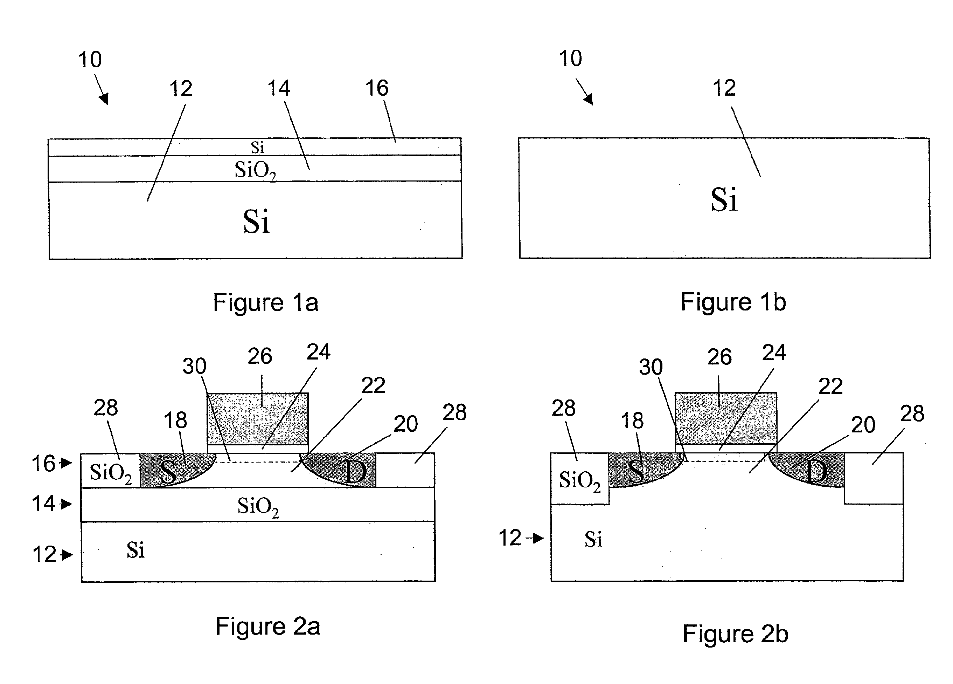

Pour bien saisir les spécificités des circuits intégrés de type "bulk", c'est à dire massif, PD-SOI et FD-SOI, on se référera avantageusement aux figures 1 et 2 qui représentent respectivement une portion de substrat et un transistor, en a de type SOI et en b de type "bulk".

Comme le montre la figure 1a, les circuits de type SOI sont réalisés sur un substrat 10 comportant, superposés, une plaque de base 12 en silicium, une couche isolante 14 en oxyde de silicium ou en saphir, et une couche de silicium 16. Dans le cas des circuits de type "bulk", le substrat 10 est formé de la plaque de base 12 uniquement, d'où son nom de "bulk", c'est à dire de masse.

Les circuits intégrés sont formés sur ces substrats par une succession d'opérations faisant appel à la photo-lithographie et au cours desquelles des couches sont partiellement enlevées, dopées, ou de nouvelles couches sont déposées.

De manière classique, les transistors à effet de champ représentés à la figure 2a comportent, formés dans la couche 16, une source 18, un drain 20 et un corps 22 intercalé entre la source 16 et le drain 20. Le corps 22 est recouvert d'un film diélectrique 24 débordant légèrement sur la source 18 et le drain 20, laquelle porte une grille 26. La couche 16 a été gravée autour de la source et du drain et remplacée par un cadre isolant 28, en oxyde de silicium. Les caractéristiques physiques de la source 18 et du drain 20 sont obtenues par dopage de la couche 16.

Lorsqu'une tension est appliquée sur la grille 26, il se forme en surface du corps 22, à l'interface avec le film 24, une zone électriquement conductrice appelée canal et portant la référence 30.

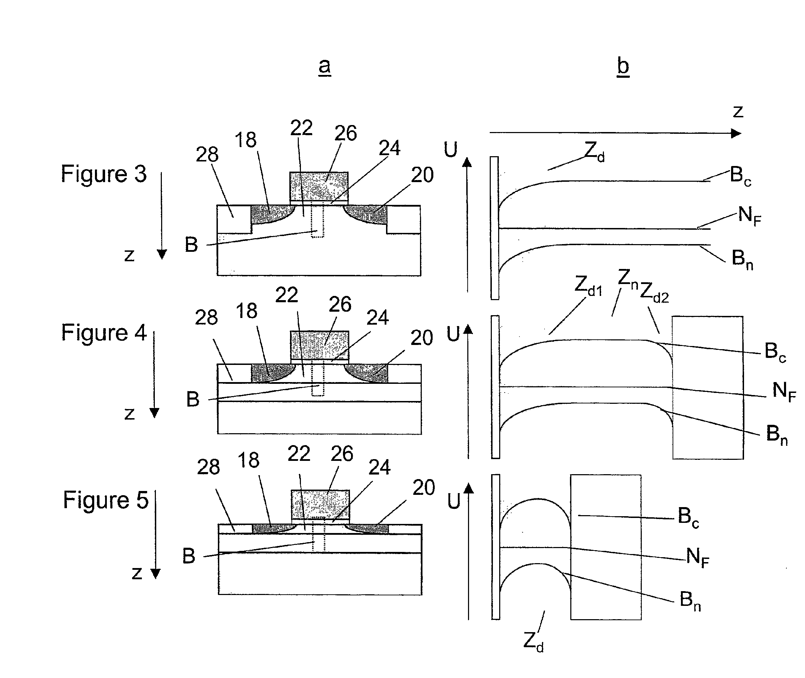

Sur la figure 2b, qui représente un transistor de type "bulk", on retrouve la source 18, le drain 20, le corps 22 interposé entre la source 18 et le drain 20, le film diélectrique 24 et la grille 26, ainsi que le cadre 28. De même, les caractéristiques physiques de la source 18 et du drain 20 sont obtenues par dopage mais, ici, de la portion supérieure de la plaque de base 12. Cette différence modifie considérablement les caractéristiques du transistor. Cela est illustré aux figures 3 à 5.

Sur ces figures, les parties a montrent respectivement un transistor de type "bulk", un transistor PD-SOI et un transistor FD-SOI, dans lesquels les mêmes parties portent les mêmes références que sur la figure 2, alors que les parties b sont des diagrammes qui montrent l'évolution du potentiel de la bande de conduction et de la bande de valence en fonction de l'épaisseur. L'épaisseur prise en compte dans les transistors de la partie a est représentée par un rectangle en traits mixtes, identifié par la référence B.

Sur les parties b des figures 3 à 5, on peut voir trois courbes Bᵥ, B_{c} et N_{F} représentant respectivement le potentiel de la bande de valence, de la bande de conduction et le niveau de Fermi à l'intérieur du corps 22, en partant du film diélectrique 24.

Il apparaît, sur ces figures, que les caractéristiques des bandes de valence Bᵥ et de conduction B_{c} ont un potentiel minimum à l'interface du corps 22 et du film diélectrique 24.

Sur la figure 3b, relative à un transistor de type "bulk", on constate que, dans une première zone Z_{d}, dite de déplétion, les potentiels de Bᵥ et B_{c} varient et tendent vers une valeur limite. Au-delà de celle-ci, commence une deuxième zone Zₙ, appelée zone neutre. Cette deuxième zone se prolonge dans toute l'épaisseur du substrat.

La figure 4b, qui se rapporte à un transistor PD-SOI, montre deux zones de déplétion Z_{d1} et Z_{d2}, respectivement attenantes au film diélectrique 24 et à la couche isolante 14, entre lesquelles est intercalée une zone neutre Zₙ.

Comme cela est expliqué dans la demande de brevet EP 01810587.4 déjà citée, il est possible de stocker une charge électrique dans le corps 22 et, plus particulièrement, dans la zone neutre Zₙ comprise entre les deux zones de déplétion Z_{d1} et Z_{d2}. Un tel transistor peut ainsi former une cellule de mémoire, susceptible de présenter deux états définis par la présence ou non d'une charge dans cette zone neutre Zₙ

Si l'on se réfère à la figure 5, qui se rapporte à un transistor FD-SOI, on constate que le corps 22 présente, dans toute son épaisseur, des bandes de conduction B_{c} et de valence Bᵥ dont le potentiel varie continuellement. Le corps comporte une zone de déplétion Z_{d} occupant toute son épaisseur. De la sorte, il n'y a pas de zone neutre, en conséquence de quoi il n'est pas possible d'utiliser un tel transistor comme cellule de mémoire, une charge électrique ne pouvant y être stockée. Or, ce type de transistor présente, par ailleurs, de nombreux avantages, par exemple un excellent comportement de canal court, généralement défini sous le vocable anglais « short-channel behaviour » et une fréquence de coupure très rapide. Ces caractéristiques avantageuses proviennent de la faible épaisseur de la couche 14.

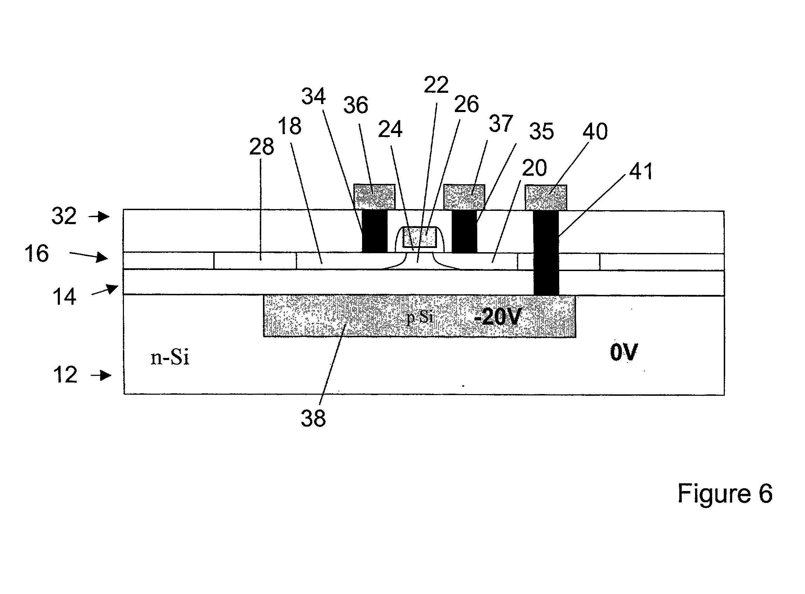

Le transistor représenté sur la figure 6 permet de profiter des avantages des transistors de type FD-SOI, tout en assurant le stockage d'une charge électrique. Il est semblable à celui représenté à la figure 5, les mêmes parties portant les mêmes références.

Pour assurer la connexion du transistor représenté avec d'autres composants que porte le substrat 10, la couche 16 est recouverte d'une couche isolante 32, percée de fenêtres remplies de matériau conducteur qui forme des plots de contact 34 et 35 respectivement reliés à la source 18 et au drain 20 et des lignes conductrices 36 et 37 respectivement en contact avec les plots 34 et 35.

De plus, la plaque de base 12, en silicium de type n, comporte, en regard de la source 18, du corps 22 et du drain 20, un caisson 38 présentant un fort dopage de type p. Ce caisson est relié électriquement à une ligne conductrice 40 par un plot de contact 41 traversant la couche 14, le cadre 28 et la couche isolante 32.

Un ensemble de transistors de ce type a été réalisé en technologie 0,13 µm, avec une couche isolante 14 de 400 nm d'épaisseur et une couche de silicium de 30 nm.

Il a été constaté qu'en appliquant une forte tension négative sur le caisson 38, typiquement de - 20 V, il se forme dans le corps 22 une zone neutre similaire à celle du transistor de la figure 4, c'est à dire de type PD, dans laquelle il est donc possible de créer, de stocker et d'effacer une charge électrique. Cette tension peut être réduite si l'épaisseur de la couche 14 est plus faible.

Un transistor de ce type peut donc être utilisé comme cellule pour stocker une information binaire, par exemple dans une mémoire DRAM ou DRAM embarquée. Les opérations permettant de créer ou d'éliminer une charge dans un tel transistor s'effectuent de manière tout à fait similaire à celle décrite dans le document EP 01810587.4, avec, en plus, l'application d'une forte tension négative, comme expliqué en référence à la figure 6. Ces opérations ne seront donc pas décrites ici de manière plus détaillée.

On relèvera que, dans les zones ne comportant pas de caisson, il est possible d'implanter d'autres transistors qui présenteront toutes les caractéristiques spécifiques au type FD-SOI. Des transistors de type FD-SOI et PD-SOI peuvent ainsi être réalisés sur un même substrat et pour une même épaisseur de silicium.

Dans une variante qui n'a pas été représentée, le caisson 38 peut être remplacé en créant, dans la couche 16, une strate inférieure à fort dopage attenante à la couche isolante 14, à la source et au drain. Cette strate induit un effet similaire.

On relèvera que le concept énoncé ci-dessus est également applicable à des circuits de type PD-SOI, lorsque l'épaisseur de la zone neutre est insuffisante.

La description a été faite sur la base de transistors de type NMOS. Il va de soi qu'il est possible d'obtenir un même résultat avec des transistors PMOS. Dans ce cas, les potentiels doivent être inversés.

## Revendications

1. Dispositif semi-conducteur à mémoire, du type comportant des transistors SOI qui comprennent une source (18), un drain (20), une grille (26) et un corps (22), et formé sur un substrat comprenant :
- une plaque de base (12) en matériau semi-conducteur,
- une couche isolante (14) disposée sur la plaque de base,
- une première couche de matériau semi-conducteur (16) recouvrant la couche isolante (14) et dans laquelle sont formés, par dopage, les sources (18), drains (20) et corps (22) desdits transistors, et
- un film diélectrique (24) disposé entre la source (18) et le drain (20) de chaque transistor et revêtu d'une couche conductrice formant la grille (26),
**caractérisé en ce qu'**une deuxième couche de matériau semi-conducteur (38) fortement dopé est disposée au moins localement en dessous de la première couche (16).

2. Dispositif selon la revendication 1, **caractérisé en ce que** lesdits transistors sont de type FD-SOI et la première couche (16) présente une épaisseur inférieure à 100 nm.

3. Substrat (10) destiné à la fabrication de circuits intégrés de type SOI, comportant
- une plaque de base (12) en matériau semi-conducteur dopé,
- une couche isolante (14) disposée sur la plaque de base, et
- une première couche de matériau semi-conducteur (16) recouvrant la couche isolante de manière homogène et destinée à être travaillée par dopage pour y former des sources, drains et corps de transistors à effet de champ,
**caractérisé en ce que** une deuxième couche de matériau semi-conducteur (38) fortement dopé est disposée au moins localement en dessous de la première couche (16).

4. Substrat selon la revendication 3, **caractérisé en ce que** la deuxième couche (38) est formée dans la plaque de base (12).

5. Substrat selon la revendication 3, **caractérisé en ce que** la deuxième couche (38) est attenante à la première couche (16).

6. Substrat selon l'une des revendications 4 et 5, **caractérisé en ce que** ladite deuxième couche forme un caisson (38) et n'occupe qu'une part de la surface de ladite plaque (12).

7. Transistor à effet de champ de type SOI à déplétion partielle (PD) et comportant un substrat (10) formé d'une plaque de base (12) en matériau semi-conducteur, d'une couche isolante (14) disposée sur la plaque de base (12) et d'une couche semi-conductrice (16) revêtant la couche isolante et dans laquelle sont formés la source (18), le drain (20) et le corps (22), et d'un film diélectrique (24) recouvrant la couche semi-conductrice (16) dans l'espace compris entre la source (18) et le drain (20) et revêtu d'une couche conductrice formant la grille (26),
**caractérisé en ce qu'**il comporte une zone (38) fortement dopée disposée au voisinage de la source (18), du corps (22) et du drain (18), du côté opposé à celui portant le film diélectrique (24).

8. Transistor selon la revendication 6, **caractérisé en ce que** la zone dopée forme un caisson (38) dans la plaque de base (12), directement adjacent à la couche isolante (14).

9. Transistor selon la revendication 6, **caractérisé en ce que** ladite zone (38) est directement formée dans la couche semi-conductrice (16), à l'interface avec la couche isolante (14).

10. Transistor selon l'une des revendications 8 et 9, **caractérisé en ce que** l'épaisseur de la couche semi-conductrice (16)est inférieure à 100 nm.
